# EUROPEAN PATENT APPLICATION

(11) **EP 1 017 164 A2**
(43) Date of publication of application: **05.07.2000**
(21) Application number: 99125651.2
(22) Date of filing: 22.12.1999
(51) Int. Cl.: H03F 3/345

(54) **Current mirror with a constant current for a wide range of output load impedance**

(30) Priority: 28.12.1998 US 222428
(71) Applicant: Xerox Corporation, Rochester, New York 14644 (US)
(72) Inventor: McIntyre, Harry J., Los Angeles, California 90066 (US); Zomorrodi, Mehrdad, West Hills, California 91304 (US)
(74) Representative: Grünecker, Kinkeldey, Stockmair & Schwanhäusser Anwaltssozietät

(57) **Abstract**

According to the present invention, there is disclosed a current mirror which utilizes two PMOS transistors and an operational amplifier to provide a substantially constant current at the output of the current mirror for a wide range of load impedance. The output of the operational amplifier is connected to the gates of both transistors and each input of the operational amplifier is connected to the drain of one of the transistors. This combination controls the voltages of the two transistors and causes the output current of the current mirror to stay substantially constant over a wide range of load impedance.

## Description

This application is related to a current mirror and more particularly to a current mirror capable of accepting a wide range of output load impedance while providing a substantially constant output current either identical or proportional to the input current.

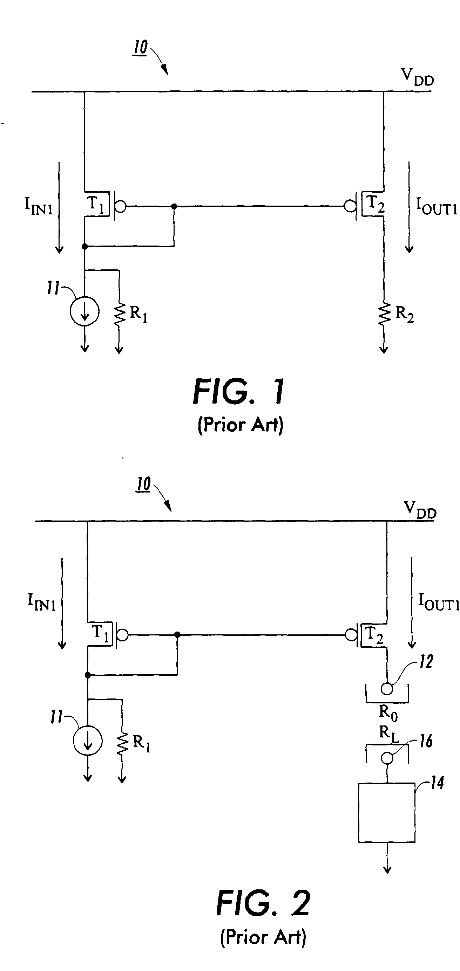

Referring to Figure 1, there is shown a typical prior art current mirror 10. In Figure 1, the current mirror 10 comprises two p-channel metal oxide field effect transistors (PMOS) T₁ and T₂. The sources of both transistors T₁ and T₂ are connected to a power supply V_{DD} and the gates of both transistors T₁ and T₂ are connected each other. Also, the gate and the drain of transistor T₁ are connected to each other. The drain of transistor T₁ is grounded through an impedance R₁ which represents the impedance of input current source 11 and the drain of transistor T₂ is grounded through an impedance R₂ which represents the output load impedance. Current source 11 supplies an input current I_{IN1} which flows through transistor T₁. Also, the gate of transistor T₁ is connected to its drain.

There are many different variations of current mirrors. However, the current mirror 10 of Figure 1 is chosen as a simple representation to discuss what current mirrors try to accomplish. A current mirror is designed to duplicate the input current I_{IN} (the current through the transistor T₁) at the output as the output current I_{OUT} (the current through transistor T₂) or to provide an output current I_{OUT} proportional to the input current I_{IN1} by a set factor.

In order to accomplish the above, first the transistors have to be selected to be identical to generate identical currents or must have a size ratio equal to the set factor. Since the sizes of the transistors, the amount of currents and voltages can be adjusted to provide proportional currents, for the purpose of simplicity, hereinafter, the discussion will include only the current mirrors that provide identical currents.

In Figure 1, the sizes of two transistors T₁ and T₂ are selected to be equal. In order to provide a similarly accurate current in both transistors, since the sources of both transistors T₁ and T₂ are connected to V_{DD}, and the gates are connected to each other, the drain voltages of both transistors have to be kept equal.

However, keeping the drain voltages the same is a challenge. The difficulty arises due to the output impedance of the current mirror and the load impedance of the external circuit which will be connected to the current mirror. Referring to Figure 2, there is shown a representation of output impedance and load impedance. The internal impedance of the current mirror, which can be observed through the output node 12 at the drain of transistor T_{2,} is called output impedance R_{O}. Also, the internal impedance of the load 14, which can be observed from node 16 (the node that will be connected to node 12), is called load impedance R_{L}.

A current mirror should act as a current source to provide a constant current for any load impedance. The ideal current source model suggests an output impedance of infinity. If the output impedance is infinity, then regardless of the load impedance, the current source provides a constant current. However, since in reality the output impedance is not infinity, depending on the value of the load impedance, the current of the current mirror changes.

In order to generate a constant current, conventional current mirrors focus on increasing the output impedance as much as possible. Also, in a current mirror, the current and voltage relationship is a function of' V_{GS} and V_{DS}, where V_{DS} is translated into channel length modulation phenomenon. When the output impedance is not infinite, different values of the load impedance change the V_{DS} and cause the output current to vary while V_{GS} stays constant. Therefore, there is always a current variation on the output current of the current mirror depending on the value of load impedance. This variation is further magnified in current mirrors which have an output current proportional to the input current by a factor of larger than 1.

It is an object of this invention to design a current mirror which can provide a substantially constant current over a wide range of impedance load.

In accordance with the present invention, there is disclosed a current mirror which utilizes two MOSFET transistors and an operational amplifier. The sources of both transistors are connected to a power supply and the gates of both transistors are connected to the output of the operational amplifier. The drain of one transistor is connected to one of the inputs of the operational amplifier and to a current source. The drain of the other transistor is connected to the other input of the operational amplifier and to a load impedance.
Figure 1 shows a typical prior art current mirror;
Figure 2 shows a representation of output impedance and load impedance;
Figure 3 shows the first step in developing the current mirror of this invention; and
Figure 4 shows the current mirror of this invention.

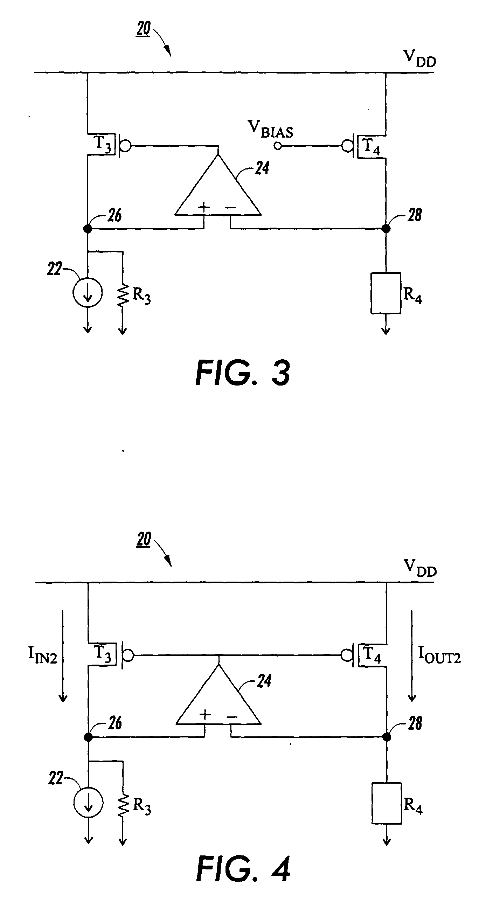

Referring to Figure 3, there is shown the first step in developing the current mirror 20 of this invention. Current mirror 20 comprises two same size PMOS transistors T₃ and T₄. The sources of both transistors are connected to V_{DD}, the drain of transistor T₃ is grounded through an impedance R₃ which represents the impedance of input current source 22, and the drain of transistor T₄ is grounded through a load impedance R₄. For the purpose of discussion, the value of the load impedance R₄ is considered unknown. The positive input of an Op-Amp 24 is connected to the drain of transistor T₃ and the negative input of the Op-Amp 22 is connected to the drain of transistor T₄. The output of the Op-Amp 24 is connected to the gate of transistor T₃. For the purpose of discussion, the gate of transistor T₄ is connected to a biasing voltage V_{BIAS}.

In this configuration, the Op-Amp 24 works in a negative feedback mode and therefore forces the two voltages at its two inputs to be substantially equal. Since nodes 26 and 28 are connected to the positive and negative inputs of Op-Amp 22, they will have substantially the same voltage. With this configuration, node 28 will have the same voltage as the voltage of node 26 regardless of the value of the load impedance. Also, with this configuration, the output of the Op-amp 24 determines the proper voltage for the gate of the transistor T₃ to force the two voltages of nodes 26 and 28 to be equal.

Referring to Figure 4, by disconnecting the gate of the transistor T₄ from the V_{BIASE2} and connecting it to the output of the Op-Amp 24, the gates of the two transistors will have the same voltage which is determined by the Op-Amp 24. In the configuration of Figure 4, which is the complete embodiment of this invention, the sources have the same voltage, the drains have the same voltage and the gates have the same voltage. Therefore, the output current I_{OUT2} is substantially equal to the input current I_{IN2}.

With the configuration of Figure 4, the Op-Amp 24 regulates the V_{GS} of both transistors T₃ and T₄ to compensate for the changes of the V_{DS} of transistor T₄ based on different load impedance. Therefore, in Figure 4, the V_{GS} of both transistors become the controlling voltage for the current mirror 20.

The disclosed embodiment of this invention provides a substantially constant_output current I_{OUT} over a wide range of load impedance.

Current mirror 20 utilizes two p-channel transistors. However, if one desires, the current mirror can be designed to use two n-channel transistors.

It should be noted that the disclosed embodiments of this invention can be designed to scale the output current. By selecting different size transistors, the output current can be set to a desired value. The ratio of the size of the output transistor to the size of the input transistor determines the ratio between the input and output currents. If the size of the output transistor is larger or smaller than the size of the input transistor then, the output current will be larger or smaller respectively.

## Claims

1. An current mirror comprising;
a first metal oxide silicon field effect transistor having a first drain voltage;
a second metal oxide silicon field effect transistor having a second drain voltage; and
a balancing means being electrically connected to said first transistor and said second transistor for causing said second drain voltage to be equal to said first drain voltage.

2. The current mirror recited in claim 1, wherein said balancing means is an Op-amp.

3. The current mirror recited in claim 1 or 2, wherein said first and second metal oxide silicon field effect transistors are p-channel metal oxide silicon field effect transistors.

4. The current mirror recited in one of claims 1 to 3, wherein said first and second metal oxide silicon field effect transistors are n-channel metal oxide silicon field effect transistors.

5. A current mirror comprising:
a first metal oxide silicon field effect transistor having a gate, a drain and a source;
a second metal oxide silicon field effect transistor having a gate, a drain and a source;
said source of said first transistor and said source of said second transistor both being electrically connected to a power supply;
an operational amplifier having a first input, a second input, and an output;
said output of said operational amplifier being electrically connected to said gate of said first transistor and said gate of said second transistor;
said first input of said operational amplifier being electrically connected to said drain of said first transistor;
said second input of said operational amplifier being electrically connected to said drain of said second transistor;
said drain of said first transistor being grounded through a current source; and
said drain of said second transistor being grounded through a load impedance.

6. The current mirror recited in claim 5, wherein said first and second metal oxide silicon field effect transistors are p-channel metal oxide silicon field effect transistors.

7. The current mirror recited in claim 5, wherein said first and second metal oxide silicon field effect transistors are n-channel metal oxide silicon field effect transistors.
